# EUROPÄISCHE PATENTSCHRIFT

(11) **EP 3 198 660 B1**
(45) Veröffentlichungstag und Bekanntmachung des Hinweises auf die Patenterteilung: **06.07.2022**
(21) Anmeldenummer: 15797002.1
(22) Anmeldetag: 28.09.2015
(51) Int. Cl.: H01L 51/48, H01L 51/56

(54) **VERFAHREN ZUM AUFBRINGEN EINER SCHUTZSCHICHT FÜR DIE HERSTELLUNG EINES HALBFABRIKATS**
METHOD FOR APPLYING A PROTECTIVE LAYER FOR THE FABRICATION OF A SEMI-FINISHED PRODUCT
PROCÉDÉ POUR APPLIQUER UNE COUCHE PROTECTRICE POUR LA FABRICATION D'UN SEMI-PRODUIT

(30) Priorität: 26.09.2014 DE 102014114035
(43) Veröffentlichungstag der Anmeldung: 02.08.2017
(73) Patentinhaber: Heliatek GmbH, 01139 Dresden (DE)
(72) Erfinder: ANDERSON, Merve, 01097 Dresden (DE); HERMENAU, Martin, 01705 Freital (DE); PFEIFFER, Martin, 01309 Dresden (DE); GERDES, Olga, 89081 Ulm (DE)
(86) Internationale Anmeldenummer: PCT/DE2015/100407
(87) Internationale Veröffentlichungsnummer: WO 2016/045668

(56) Entgegenhaltungen:
- EP-A2- 2 200 105
- DE-A1-102006 015 043
- DE-A1-102009 025 123
- US-A1- 2006 246 811
- US-A1- 2013 118 582
- US-A1- 2014 230 846
- Kapitel 11a: "Slot Coating" In: S.F. Kistler, P.M. Schweizer (Eds.), F. Durst, H.G. Wagner: "Liquid Film Coating", 1997, Chapmann & Hall, London pages 401-426,
- "Problems in slot, extrusion, slide and curtain coating" In: E.B. Gutoff, E.D. Cohen: "Coating and Drying Defects: Troubleshooting Operating Problems, 2. Auflage", 2006, Wiley & Sons, New Jersey pages 97-142,
- Kapitel 4: "Aufbau eines Wickels" und Kapitel 6: "Reduzierung von Lufteinschlüssen": In: W. Taube: "Erfahrungen und Grundlagen der Wickeltechnik: Theoretische Überlegungen zum zentralen Wickeln von flachen geschlossenen Warenbahnen", 2011, SomaTec, Aerzen-Groß Berkel

## Beschreibung

### Gebiet der Erfindung

Die Erfindung betrifft eine Schutzschicht, auch als Wickelschutzschicht bezeichnet, und ein Verfahren zum Aufbringen einer Schutzschicht im Rahmen eines kontinuierlichen Rolle-zu-Rolle-Verfahrens zur Herstellung eines beschädigungsfrei handhabbaren Halbfabrikats organischer elektronischer Bauelemente, insbesondere optoelektronischer Bauelemente, wie Solarzellen oder LED, TFT etc.

### Stand der Technik

Organische Elektronik ist ein Teilgebiet der Elektronik, das elektronische Schaltungen aus elektrisch leitfähigen Polymeren oder kleineren organischen Verbindungen verwendet.

Merkmal der organischen Elektronik ist die Verwendung mikroelektronischer Bauelemente auf Trägermaterialien aus organischen Folien sowie Leiterbahnen und Bauelemente, die aus leitfähigen organischen Molekülen (organischen Halbleitern) gefertigt werden. Die organischen Materialien werden dabei in Form dünner Filme oder kleiner Volumen auf die Folien aufgedruckt, aufgeklebt, gecoated, aufgedampft oder anderweitig angebracht. Für die Herstellung der dünnen Schichten kommen ebenso alle Verfahren in Betracht, die auch für Elektronik auf keramischen oder halbleitenden Trägern verwendet werden.

Optoelektronische Bauelemente finden heute eine breite Anwendung im alltäglichen sowie industriellen Umfeld. Von besonderem Interesse sind dabei Bauelemente mit organischen Schichten, welche aufgrund ihrer flexiblen Ausgestaltung eine Anordnung auf gekrümmten oder gewölbten Oberflächen erlauben.

Organische Elektronik ist in vielen Anwendungsgebieten redundant zur Siliziumtechnologie, weist aber Vorteile auf wie niedrige Kosten, wodurch sie unter anderem geeignet ist Einwegelektronik, oder niedrige Gesamtdicke der Bauelemente, wodurch sie leichter integrierbar ist. Die Herstellung der dünnen Schichten ist unter sehr viel milderen Bedingungen möglich, so dass als Substrate auch flexible Kunststofffolien möglich sind und so in sich flexible und zum Teil dehnbare Bauelemente möglich sind.

Bekannt sind zudem organische Leuchtdioden (OLED), welche aufgrund der nicht benötigten Hintergrundbeleuchtung sehr dünn und damit auch flexibel ausgestaltet werden können. Weiterhin bekannt sind auch Solarzellen mit organischen aktiven Schichten, welche flexibel ausgestaltet sind. Die organischen aktiven Schichten können dabei aus Polymeren, beispielsweise beschrieben in der Druckschrift US 7 825 326 B2, oder kleinen Molekülen, wie aus der Druckschrift EP 2 385 556 A1 bekannt, aufgebaut sein. Weitere Anwendungen finden sich zum Beispiel in Lichtsensoren oder Feldeffekttransistoren.

Die elektronischen Bauelemente umfassen mindestens zwei Elektroden, wobei eine auf dem Substrat aufgebracht ist und die andere als Gegenelektrode auf der vom Substrat abgewandt aufgebracht ist. Zwischen den Elektroden befindet sich mindestens eine photoaktive Schicht, vorzugsweise eine organische photoaktive Schicht. Weitere Schichten, beispielsweise Transportschichten, können zwischen den Elektroden angeordnet sein.

Während Polymere sich dadurch auszeichnen, dass diese nicht verdampfbar und daher nur aus Lösungen aufgebracht werden können, sind kleine Moleküle meist verdampfbar und können durch verdampfen oder sublimieren mit oder ohne Trägergas lösungsmittelfrei verarbeitet werden.

Der Vorteil solcher Bauelemente auf organischer Basis gegenüber den konventionellen Bauelementen auf anorganischer Basis, insbesondere Halbleitern wie Silizium oder Galliumarsenid, sind die teilweise extrem hohen optischen Absorptionskoeffizienten organischer Materialien bis zu 2 × 10⁵ cm⁻¹, so dass sich die Möglichkeit bietet, mit geringem Material- und Energieaufwand sehr dünne Bauelemente herzustellen. Weitere technologische Aspekte sind die niedrigen Kosten, die Möglichkeit, flexible großflächige Bauteile auf Plastikfolien herzustellen, und die nahezu unbegrenzten Variationsmöglichkeiten und die unbegrenzte Verfügbarkeit der organischen Chemie.

Eine Solarzelle wandelt Lichtenergie in elektrische Energie um, während eine OLED elektrische Energie in Licht umwandelt. Der Begriff photoaktiv bezeichnet hierbei ebenfalls die Umwandlung von Lichtenergie in elektrische Energie und umgekehrt. Im Gegensatz zu anorganischen Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in freie Ladungsträger getrennt, die dann zum elektrischen Stromfluss beitragen. Bekannte Ausgestaltungen organischer Solarzellen sind beispielsweise in den Druckschriften WO 2004 083 958 A2, WO 2006 092 135 A1, WO 2006 092 134 A1, EP 107 25 079 A1, WO 2010 139 804 A1 sowie WO 2011 064 330 A1 offenbart.

Die Herstellung von optoelektronischen Bauelementen erfolgt in Abhängigkeit der verwendeten organischen Materialien in der aktiven organischen Schicht durch Sputtern, Spin Coating oder Bedrucken sowie durch Abscheidung aus der Dampfphase (CVD, OVPD) und durch Strukturierungsmaßnahmen wie Laserstrukturierung oder nasslithographische Strukturierung.

Unter einem Rolle-zu-Rolle-Verfahren wird dabei eine kontinuierliche Verfahrensführung verstanden, die im Gegensatz zu einem Batch-Verfahren, in dem einzelne Bauteile nacheinander prozessiert werden, steht. Im Allgemeinen bedeutet eine kontinuierliche Verfahrensführung, dass ein technischer Herstellungsprozess ohne Unterbrechungen durchgeführt wird. Dabei wird vorzugsweise das Substrat bzw. das herzustellende Bauelement kontinuierlich weitergeführt. Im Speziellen bedeutet dies, dass zumindest Halbfertigteile oder Halbzeuge oder Bauelemente in mehr als einem Verfahrensschritt mit einem kontinuierlichen Verfahren hergestellt werden, z.B. eine Substratfolie aus einer Trägerfolie mit einem leitfähigen Schichtstapel. Das Rolle-zu-Rolle-Verfahren ist beispielsweise durch ein fortlaufendes Band aus einer Kunststofffolie, beispielsweise PET oder PEN, gekennzeichnet. Auf dieses Band werden zur Ausbildung elektronischer Bauelemente Materialien aufgetragen, insbesondere durch Aufdampfen, Drucken, Coaten, Sputtern oder Plasmaabscheiden, und strukturiert durch beispielsweise lasern, ätzen, kratzen oder schneiden

Ein Problem bei der Herstellung optoelektronischer Bauelemente mit organischen Schichten im Rolle-zu-Rolle-Verfahren ist, dass die Substrate nur durch eine elektrische Isolierung voneinander getrennt sind, in der Regel eingebracht durch Laserprozesse oder lithographisch-chemische oder mechanische Prozesse. Die Substrate befinden sich auf der Rolle und müssen zur Fertigstellung sowohl voneinander getrennt als auch hinreichend vor äußeren Umwelteinflüssen versiegelt werden, sobald sie das kontinuierliche Rolle-zu-Rolle-Verfahren verlassen.

Zwar ist es vorteilhaft für die vollständige Produktion mehrere, aufeinanderfolgende Rolle-zu-Rolle-Anlagen zu verwenden, welche je nach Anforderung unter atmosphärischen, inerten oder Niederdruckbedingungen betrieben werden können, um die Komplexität der Einzelanlagen zu verringern. So ist es beispielsweise sinnvoll eine Rolle-zu-Rolle-Anlage zur Herstellung der organischen Bauelemente und eine weitere Anlage zur weiterführenden Verkapselung dieser zu verwenden, da die Prozessumgebungen dieser beiden Produktionsschritte maßgeblich voneinander verschieden sein können. Die prozesstechnische Trennung geschieht hierbei beispielsweise nach der vollständigen Abscheidung und Strukturierung der funktionalen organischen Bauelemente (vgl. Druckschrift DE 10 2012 106 607 A1).

Problematisch ist jedoch dabei, dass die schon fertigen Schichten zwischen den Arbeitsschritten immer vor Feuchtigkeit, Lösungsmitteln und/oder mechanischem Stress bewahrt werden müssen. Hinzu kommt die zumeist geringe Haftung zwischen dem organischen Schichtstapel und der Gegenelektrode, weswegen eine Auf- und Abwicklung des fortlaufenden Substrates mitsamt dem vollständigen Schichtstapel mit hoher Wahrscheinlichkeit zu einer Schädigung der organischen Bauelemente, welche sich auf dem fortlaufenden Substrat befinden, führt.

Zum Schutz des Halbfabrikats wird daher eine Schutzschicht benötigt (vgl. z. B. die Druckschriften DE 10 2004 024 461 A1, DE 10 2011 075 081 A1 und DE 10 2010 014 299 A1). Diese gibt Gewähr für einen schadensfreien Transfer in eine Folgemaschine sowie eine unempfindlichere Weiterverarbeitung des Halbfabrikats, bei der auch Berührungen auf beiden Seiten der Folie möglich sind.

Als Schutzschicht wird nach dem Stand der Technik eine Polymerfolie aufgebracht. Eine vorgefertigte Folie weist aber ohne besondere Maßnahmen, beispielsweise eine aufwändige Trocknung, eine hohe Feuchtigkeit auf. Dies führt jedoch zu Schäden am abzudeckenden, feuchteempfindlichen Bauelement.

Andere Verfahren für die Ausbildung einer Deckschicht sind bekannt, können jedoch für die Herstellung einer Schutzschicht nach dem Oberbegriff der Erfindung nicht herangezogen werden. So sieht das Verfahren nach der Druckschrift DE 10 2008 026 216 B4 den Auftrag eines Lacks vor, dessen den Schichtstapel schädigender Lösemittelgehalt das Verfahren aber für den vorliegenden Zweck ungeeignet macht. Weiterhin ist es aus der Druckschrift DE 10 2009 025 123 A1 bekannt, Schichten durch die Extrusion eines Polymers aus einer Breitschlitzdüse aufzubringen. Die relativ hohen Temperaturen, die zum Schmelzen des Polymers erforderlich sind, und die aus dem Extrusionsvorgang resultierende mechanische Belastung führen dazu, dass dieses Verfahren ebenfalls nicht eingesetzt werden kann, um eine Schutzschicht, die unmittelbar den organischen Schichtstapel bedecken soll, aufzubringen.

EP2200105 beschreibt ein Verfahren zur Herstellung einer Kapselung einer elektronischen Anordnung, wobei die Kapselung aus der Schmelze aufgetragen werden kann.

### Zusammenfassung der Erfindung

### Technische Aufgabe

Es besteht daher ein besonderes Bedürfnis, Verfahren zu entwickeln, mit welchen eine permanente Schutzschicht auf der Gegenelektrode eines Schichtstapels eines elektronischen Bauelements aufgebracht werden kann, die sich dadurch auszeichnet, dass keine negativen Wechselwirkungen mit dem zu schützenden Schichtstapel des elektronischen Bauelements auftreten. Das Verfahren soll zudem in die zur Herstellung des organischen Halbfabrikats verwendeten Rolle-zu-Rolle-Prozesse integrierbar sein.

Die Aufgabe der vorliegenden Erfindung besteht daher darin, ein Verfahren zum Aufbringen einer Wickelschutzschicht für die Herstellung eines Halbfabrikats bereitzustellen, so dass der Schichtstapel des elektronischen Bauelements für die Phase der Endfertigung vor Umwelteinflüssen und durch Beschädigungen bei der Weiterverarbeitung geschützt ist. Weder die aufgebrachte Schutzschicht selbst noch das Verfahren zur Herstellung bzw. zum Aufbringen der Schutzschicht dürfen nachteilige Auswirkungen auf die weitere Verarbeitung des Halbfabrikats oder die zu schützenden Funktionsschichten des Schichtstapels aufweisen. Weiterhin ist gefordert, dass das Verfahren zur Herstellung der Schutzschicht einfach, flexibel und kostengünstig ist und in den Rolle-zu-Rolle-Prozess integrierbar ist.

### Technische Lösung

### Verfahren zum Aufbringen einer Schutzschicht

Die Aufgabe wird gelöst durch ein Verfahren zum Aufbringen einer Schutzschicht im Rahmen eines kontinuierlichen Rolle-zu-Rolle-Verfahrens zur Herstellung eines Halbfabrikats organischer elektronischer Bauelemente gemäß Anspruch 1, umfassend einen Schichtstapel auf einer Substratfolie, wobei die Schutzschicht den Schichtstapel vor und während der Endfertigung vor Umwelteinflüssen und durch die Handhabung bedingten Beschädigungen schützt, wobei mittels Auftrags durch ein zumindest temporär in der Phase des Auftragens fluides, vernetz- oder aushärtbares und mit dem Schichtstapel in fluider und in fester Phase sowie mit den Bedingungen während des Rolle-zu-Rolle-Verfahrens kompatibles Schutzschichtmaterial in der Weise aufgetragen wird, dass sich eine funktionelle Schutzschicht herausbildet. Kompatibel zu dem Schichtstapel ist das Material, wenn es keine nachteiligen Einflüsse auf den Schichtstapel ausübt, kompatibel zu dem Verfahren ist das Material, wenn es weder Störungen im Verfahrensablauf hervorruft, noch sich selbst durch die Bedingungen während des Verfahrensablaufs in einer Weise verändert, die mit Nachteilen für das Material selbst, den Schichtstapel oder das Verfahren verbunden wäre.

Eine bevorzugte Ausführung sieht vor, dass es sich bei dem mit der Schutzschicht zu versehenden Halbfabrikat um ein optoelektronisches Bauelement handelt. Dazu gehören emittierende Bauelemente wie OLEDs oder Energiewandler wie Photovoltaikmodule und Lichtsensoren, aber auch Feldeffekttransistoren.

Eine besonders bevorzugte Ausführungsform umfasst als zu schützenden Schichtstapel, ein optoelektronisches Bauelement, umfassend mindestens zwei Elektroden, wobei eine Elektrode auf einem Substrat, das optional eine Barrierefunktion gegen Wasserdampf, Sauerstoff oder Wasser umfasst, aufgebracht ist und die andere als Gegenelektrode auf der vom Substrat abgewandten Seite aufgebracht ist, weiterhin umfassend mindestens eine photoaktive Schicht zwischen den Elektroden. Bevorzugt wird der zu schützende Schichtstapel überwiegend durch Verdampfen oder Sublimieren kleiner Moleküle mit oder ohne Trägergas auf einem Substrat hergestellt. Der zu schützende Schichtstapel kann noch weitere funktionale Schichten, beispielsweise Transport- oder Passivierungsschichten, umfassen.

Es hat sich als sinnvoll herausgestellt, dass Schutzschichtmaterialien verwendet werden, die im flüssigen Zustand wasser- und lösungsmittelfrei sind. Dadurch wird die Auslösung/Auflösung der organischen Materialien aus dem Schichtstapel, beispielsweise durch Diffusion, vermieden oder verringert.

Weiterhin ist die optimale Anpassung an die Bedingungen im Herstellungsprozess des Halbfabrikats vorgesehen, so kann das Aufbringen der Schutzschicht unter niedrigerem Druck, also Unterdruck, erfolgen.

Weiterhin ist vorgesehen, dass der Herstellungsprozess zum Aufbringen der Schutzschicht im Vakuum erfolgt, bevorzugt im Grob- oder Feinvakuum.

Alternativ erfolgt die Anpassung auch durch eine Vorbehandlung des Druckmaterials, z. B. durch Ausgasen gelöster Gase vor dem Einsatz im Vakuum.

Eine alternative Ausgestaltung des erfindungsgemäßen Verfahrens sieht vor, dass der Auftrag des Schutzmaterials mit oder ohne Trägergas erfolgt.

Bei einer bevorzugten Ausführungsform wird die funktionelle Schutzschicht mit einer Dicke von mindestens 50 nm und höchstens 200 µm hergestellt, besonders bevorzugt mit einer Dicke von mindestens 5 µm und höchstens 100 µm.

Als besonders vorteilhaft hat sich jedoch der Auftrag des Schutzschichtmaterials in einem Druckverfahren herausgestellt. Beim Drucken ist eine große Vielfalt von einzusetzenden Materialien verfügbar, so dass die Auswahl nach Kriterien erfolgen kann, die insbesondere die Verträglichkeit mit dem Schichtstapel und mit den vorgesehenen Prozessbedingungen berücksichtigen. So wird auf Druckmaterialen verzichtet, die mit dem organischen Schichtstapel unverträgliche Lösemittel oder Feuchtigkeit aufweisen, bei denen ein Verdampfen die Aushärtung der aufgetragenen Schicht bewirken soll. Stattdessen sind andere, an die Anforderungen des Schichtstapels angepasste Verfahren zur Vernetzung (Aushärten) des Schutzschichtmaterials nach dem Drucken vorgesehen. Bevorzugt werden aber lösungsmittelfreie Tinten eingesetzt.

Als Druckverfahren ist wenigstens eines der Verfahren Siebdruck, Flexoprint, Schlitzdüsen-Druck (slot die printing/coating), Plotten oder Tintenstrahldruck oder ein zum 3-D-Druck geeignetes Verfahren vorgesehen. Dabei ist Siebdruck geeignet, schnell große Flächen zu beschichten. Es sind eine Ebenenjustierung und der Einsatz der Dickschichttechnologie (einige 100 nm) möglich. Mit Schlitzdüsen können ebenfalls schnell größere Flächen beschichtet werden. Das Material wird dabei nicht als strang- oder bahnförmiges Extrudat aufgebracht (extrusion coating), sondern in flüssiger Form (slot die printing/coating). Der Tintenstrahldruck wiederum ist leicht anwendbar. Besonders vorteilhaft für polymere LEDs ist das Plotten, da es leicht anwendbar ist, große Flächen beschichtet werden können und gleichfalls eine Ebenenjustierung möglich ist.

Durch den Einsatz von Verfahren, die beim 3-D-Druck genutzt werden, ist es hingegen besonders einfach, der erzeugten Schutzschicht eine gewünschte Topografie zu verleihen. Der Aufbau beim 3-D-Druck erfolgt computergesteuert aus einem oder mehreren flüssigen oder festen Werkstoffen nach vorgegebenen Maßen und Formen (CAD). Beim Aufbau finden physikalische oder chemische Härtungs- oder Schmelzprozesse statt. Typische Werkstoffe für das 3D-Drucken sind Kunststoffe, Kunstharze, Keramiken und Metalle - demnach ein sehr breites Spektrum an einsetzbaren Werkstoffen. Insbesondere umfasst das erfindungsgemäße Verfahren die folgenden Verfahren.

In einer Ausführungsform der Erfindung hat sich das Verfahren Fused Deposition Modeling (FDM, deutsch: Schmelzschichtung) herausgestellt, dass ein Fertigungsverfahren aus dem Bereich des Rapid Prototyping bezeichnet, mit dem ein Werkstück schichtweise aus einem schmelzfähigem Kunststoff aufgebaut wird. Dieses Verfahren basiert auf der Verflüssigung eines drahtförmigen Kunststoff- oder Wachsmaterials durch Erwärmung. Beim anschließenden Abkühlen erstarrt das Material. Der Materialauftrag erfolgt durch Extrudieren mit einer in der Fertigungsebene frei verfahrbaren Heizdüse. Die Schichtdicken liegen nach dem bislang bekannten Stand der Technik zwischen 0,025 bis 1,25 mm. Dadurch lässt sich die erfindungsgemäße Schutzschicht besonders einfach mit einer gewünschten Textur versehen. Vorteilhaft vor allem gegenüber anderen Verfahren der Extrusion von Polymeren ist die geringe Materialmenge, die die Heizdüse auf einmal verlässt. Dadurch kann auch - trotz unter Umständen höherer Materialtemperatur - der Wärmeeintrag auf den Untergrund, beispielsweise den Schichtstapel kontrollieren. So kann gezielt die Menge an heißem Schutzschichtmaterial, die in einer bestimmten Zeit an einer bestimmten Stelle aufgetragen wird, so eingestellt werden, dass die Temperatur im Untergrund einen Grenzwert nicht überschreitet. Ist das aufgetragene Material an einer Stelle entsprechend abgekühlt, kann nochmals Material aufgetragen werden, um die gewünschte Schichtdicke oder Textur zu erhalten.

Ein weiteres zur Ausführung der vorliegenden Erfindung geeignetes 3-D-Druckverfahren ist das Multi Jet Modeling. Der Begriff Multi-Jet Modeling (MJM) (auch Polyjet-Modeling) bezeichnet ein Verfahren des Rapid Prototyping, bei dem ein Modell durch einen Druckkopf mit mehreren linear angeordneten Düsen, der ähnlich wie der Druckkopf eines Tintenstrahldruckers funktioniert, schichtweise aufgebaut wird. Aufgrund der geringen Größe der mit diesen Systemen erzeugten Tröpfchen können auch feine Details bzw. dünne Schichten dargestellt werden. Eine Druckauflösung von 450 dpi und besser ist technisch möglich. Als Werkstoffe für eine derart gefertigte Schutzschicht kommen UV-empfindliche Photopolymere in Frage. Diese Druckmaterialien in Form von Monomeren werden unmittelbar nach dem Aufdrucken mittels UV-Licht polymerisiert und dabei vom flüssigen Ausgangszustand in den festen Endzustand überführt. Durch den Einsatz eines Zweikopfsystems können auch unterschiedliche Materialien kombiniert werden, etwa um verschiedene Eigenschaften zu kombinieren oder einen optischen Effekt zu erzielen.

Die Vernetzung oder Aushärtung des Schutzschichtmaterials umfasst wenigstens eines der Verfahren UV-Vernetzung, wie zuvor bereits zum Multi Jet Modeling dargelegt, thermische Vernetzung durch den bevorzugt lokalen Einsatz einer Wärmequelle, die den Schichtstapel nicht schädigt, und Trocknung. Mit Trocknung ist dabei nicht die Trocknung durch das Verdampfen von Wasser oder Lösungsmitteln gemeint, da Wasser oder Lösungsmittel im Schutzschichtmaterial den Schichtstapel schädigen würden.

Zum Einsatz kommt ein Schutzschichtmaterial, das im flüssigen Zustand wasser- und lösungsmittelfrei ist, um keine Schädigung des organischen Schichtstapels hervorzurufen. Bevorzugt ist das Schutzschichtmaterial elektrisch isolierend, zumindest nach der Vernetzung. Weiterhin 2. weist das Schutzschichtmaterial einen Dampfdruck 2. auf, der unter dem beim Herstellungsverfahren vorgesehenen Umgebungsdruck liegt. Dadurch kann es unter dem gegebenenfalls niedrigen Druck bei der Verarbeitung im Rolle-zu-Rolle-Verfahren in der jeweiligen Anlage nicht zu einem unerwünschten Verdampfen des Schutzschichtmaterials kommen.

Erfindungsgemäß ist vorgesehen, dass als Schutzschichtmaterial Materialien wenigstens eine der Materialgruppe Thermoplaste, Duroplaste oder Elastomere verwendet werden.

Weiterhin ist nach der Erfindung vorgesehen, dass wenigstens eine der Materialgruppen Phenoplaste, Aminoplaste, ungesättigte Polyester-Harze, Vinylester-Harze, Epoxid-Harze, Silicon-Harze z.B. Silizium-Acrylat basierte Harze, Epoxysiloxane, Dicyclopentadien oder Diallylphthalat-Harze als Schutzschichtmaterial vorgesehen ist.

Weiterhin erfindungsgemäß ist vorgesehen, dass als Schutzschichtmaterialien aromatische, aliphatische, halogenfreie oder halogenhaltige Polyolefine, oder aromatische, aliphatische, gesättigte oder ungesättigte Polyester, oder Polyamide, oder Polyurethane, oder Phenolformaldehydharze oder Poly(organo)siloxane verwendet werden.

Bei Untersuchungen hat sich herausgestellt, dass das aufzutragende Schutzschichtmaterial eine bestimmte Mindestviskosität aufweisen muss, damit das Schutzschichtmaterial nicht von dem Schichtstapel herstellungsbedingt herunterläuft, wenn keine speziellen Randbegrenzungen vorgesehen sind. Als besonders günstig hat es sich erwiesen, wenn die Viskosität des Schutzschichtmaterials während des Auftragens mindestens bei 10 mPa.s liegt, bevorzugt größer als 50 mPa.s, besonders bevorzugt größer als 10² mPa.s liegt. Weiterhin ist um einen formflüssigen Auftrag des Schutzschichtmaterial zu gewährleisten sicher zu stellen, dass das Schutzschichtmaterial eine entsprechende Maximalviskosität während des Auftragens besitzt, damit das Schutzschichtmaterial noch erfindungsgemäß sauber aufgetragen werden kann, und herstellungsbedingte Unebenheiten, beispielsweise durch das Laserprozessieren, komplett eingebettet werden. Ist die Viskosität des Schutzschichtmaterials zu hoch, besteht die Gefahr, dass die Deckkontakte in die darunter liegenden Schichten des Stacks gedrückt werden, was zu einer ungewünschten Beschädigung führt. Als besonders günstig hat es sich erwiesen, wenn die Viskosität des flüssigen Schutzschichtmaterials maximal bei 5 * 10⁵ mPa.s, besonders bevorzugt maximal bei 10⁴ mPa.s ist; ganz besonders bevorzugt maximal etwa 10³ mPa.s liegt.

Alternativ kann das verwendete Schutzschichtmaterial vorpolymerisiert sein, um eine bestimmte Mindestviskosität zu erreichen.

Als besonders günstig hat es sich erwiesen, wenn die funktionelle Schutzschicht zumindest eine der Zusatzfunktionen Glätten des Schichtstapels, Höhenausgleich mit dem Schichtstapel, verbesserte Haftung einer Verkapselung und Freihalten von Kontaktierungsstellen ausfüllt oder beigemischte Getter aufweist.

Der Höhenausgleich kann beispielsweise dazu genutzt werden, um ein Halbfabrikat zu erhalten, dass eine gleichmäßige Schichtdicke aufweist. Das wird dadurch erreicht, dass auf herstellungsbedingt tieferliegende Bereiche mehr Schutzschichtmaterial aufgetragen wird als auf höherliegende Bereiche, wie den Schichtstapel. Nach dem Auftrag der Schutzschicht ist das Halbfabrikat mit Schutzschicht planar.

Dies erleichtert die nachfolgende Weiterverarbeitung, beispielsweise die Einbettung zwischen rigide Materialien.

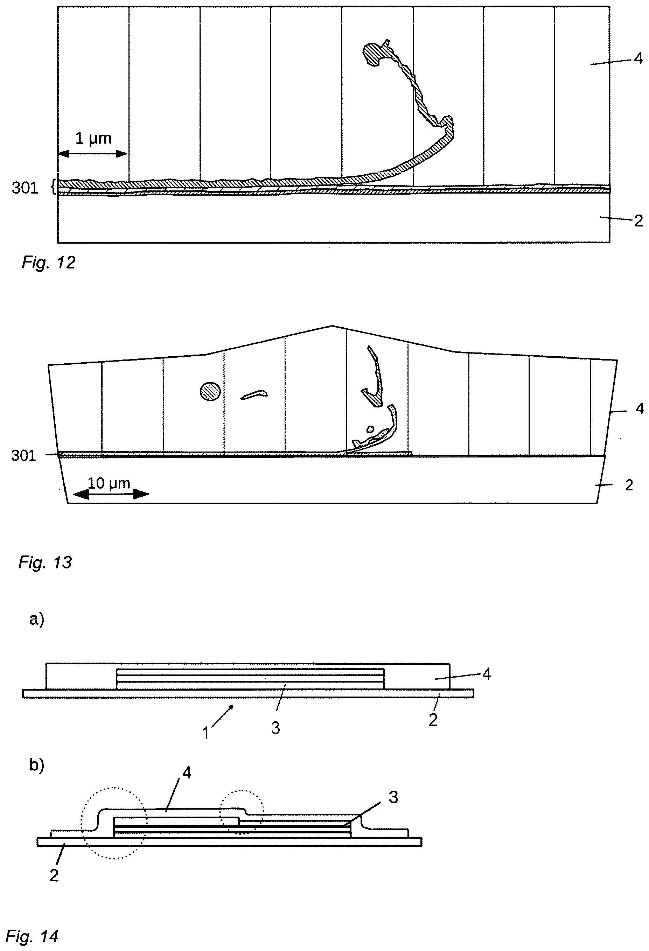

Im Gegensatz dazu wird unter dem Glätten des Schichtstapels verstanden, wenn das Halbfabrikat mit einer Schutzschicht versehen wird, so dass kleine herstellungsbedingte "Grate" ausgeglichen werden, aber an sich eine etwa gleichmäßige Schichtdicke der Schutzschicht aufgetragen wird, so dass die Schutzschicht das optoelektronische Bauelement abdeckt und herstellungsbedingte Unstetigkeiten abgedeckt werden. Dadurch erhält man ein Halbfabrikat mit Schutzschicht, welches nicht vollständig planar ist. Fig. 13 zeigt den Unterschied zwischen Höhenausgleich (a) und Glätten (b). In den Bereichen der gestrichelten Kreise beim Glätten soll der Unterschied der Begriffe hervorgehoben werden.

Bei beiden Verfahren Glätten des Schichtstapels und Höhenausgleich ist zu gewährleisten, dass das optoelektronische Bauelement mindestens so weit abgedeckt wird, dass die durch das Herstellen bedingten Unebenheiten, beispielsweise durch die Laserprozessierung der Deckelektrode, abgedeckt sind. Die Haftung der anschließenden Verkapselung auf der Schutzschicht kann verbessert werden, indem die Schutzschicht eine entsprechende Struktur erhält, beispielsweise eine raue Struktur zur Verbesserung der Kleberhaftung. Zudem wäre es möglich, die Verkapselung durch einen Formschluss mit der Schutzschicht zu verbinden, indem bevorzugt zueinander komplementäre Strukturen in Schutzschicht und Verkapselung eingebracht werden,

Weiterhin ist erfindungsgemäß vorgesehen, dass eine Zusatzschicht auf die Schutzschicht aufgebracht ist. Diese ist so ausgewählt, dass diese ein Ablösen der Elektrode von dem Stack beim Abrollen verhindert, insbesondere bei längeren Lagerzeiten bis zur Weiterverarbeitung.

Die Zusatzschicht kann temporär in Form einer Folie aufgebracht werden, um bei der Weiterverarbeitung beim Abrollen des Halbfabrikats wieder entfernt werden zu können.

Alternativ kann die Zusatzschicht auch als permanente Schicht aufgebracht werden, beispielsweise zur Haftvermittlung bei einer direkt anschließenden Verkapselung. Die Materialien für die Zusatzschicht sind aus den Materialien der Schutzschicht ausgewählt. Alternativ können auch transparente anorganische Materialien zum Einsatz kommen.

Weiterhin ist vorgesehen, dass vor dem Aufbringen der Schutzschicht eine Zusatzschicht auf dem Schichtstapel des optoelektronischen Bauelements aufgebracht wird, um attraktive Zusatzfunktionen, wie beispielsweise Lichteinkopplung, einzubinden.

Als Vorteil hat sich auch die einfache Möglichkeit eines Freihaltens von Kontaktierungsstellen erweisen. Ohne diese zuvor abdecken oder nachträglich von einer Schutzschicht befreien zu müssen, kann beim Druckvorgang, besonders flexibel bei allen kopfbasierten Druckverfahren, die Oberfläche so beschichtet werden, dass der Bereich der Kontakte und/oder der busbars von vornherein von Schutzschichtmaterial freigehalten und nicht mit bedruckt wird.

In dem Zusammenhang ist es auch vorgesehen, das Freihalten der Kontakte auf einfache Weise auch dann zu erreichen, wenn das gewählte Druckverfahren dies zunächst nicht ermöglicht. Dies ist insbesondere auch bei einem Auftrag des Schutzschichtmaterials mit Hilfe einer Breitschlitzdüse der Fall, die die Fläche auf der gesamten Düsenbreite mit dem flüssigen Schutzschichtmaterial bedeckt, ohne dass einzelne Bereiche davon ausgenommen werden könnten. Erfolgt dann die Vernetzung durch einen UV-Strahler oder eine andere geeignete Strahlungsquelle, kann dies selektiv so erfolgen, dass die vorgesehenen Kontaktbereiche unvernetzt bleiben und leicht abgewischt, abgespült oder sonst wie von dem flüssigen Schutzschichtmaterial befreit werden können, während die übrigen Bereiche bereits vernetzt und fest mit dem Untergrund verbunden sind.

Weiterhin ist es vorgesehen, wenigstens einen Getter beizumischen. Ein Getter ist im Grunde ein reaktives Material, das in der Regel dazu dient, unerwünschte Stoffe wie beispielsweise Wasser oder Sauerstoff an sich zu binden. An der Oberfläche eines Getters gehen Gasmoleküle mit den Atomen des Gettermaterials eine direkte chemische Verbindung ein oder die Gasmoleküle werden durch Sorption festgehalten. Ein entsprechender Effekt soll gemäß der vorliegenden Erfindung durch das Einbringen bzw. Beimischen eines Gettermaterials in die aufzubringende Schutzschicht, demnach in das Schutzschichtmaterial, erfolgen. Ebenfalls ist es vorgesehen, das Gettermaterial in einem gesonderten Arbeitsschritt zumindest auf den Schichtstapel aufzubringen, bevor das Schutzschichtmaterial aufgetragen wird.

Durch einen solchen Getter können unerwünschte Stoffe vom Schichtstapel ferngehalten werden, wie z. B. eindringende Feuchtigkeit. Hier zeigt sich wiederum die Überlegenheit des erfindungsgemäßen Verfahrens, denn in einer fertigen Folie, wie sie nach dem Stand der Technik als Schutzschicht aufgebracht wird, wäre ein in die Folie eingebrachtes Gettermaterial schon vor dem Aufbringen "verbraucht", da die Folie stets Feuchtigkeit aufnimmt und diese an den Getter abgibt. Entsprechendes ist bei einem gesondert aufgebrachten Gettermaterial der Fall. Dann würde zwar der Getter die feuchte Folie teilweise "trocknen", stünde aber dann für die Aufnahme zusätzlich eingedrungener Feuchtigkeit und zum Schutz eines Schichtstapels nicht mehr zur Verfügung.

Eine Ausführungsform der Schutzschicht sieht vor, dass die funktionelle Schutzschicht als eine der Zusatzfunktionen eine Vorbereitung von nach der Verkapselung wirksamen optischen Effekten umfasst. Dies kann beispielsweise eine die Lichtein- oder -auskopplung verstärkende Schicht umfassen. Die vorgenannten Druckverfahren ermöglichen dabei die Herstellung einer diese Effekte unterstützenden Textur.

### Schutzschicht

Die Aufgabe der Erfindung wird weiterhin gelöst durch ein Verfahren zum Aufbringen einer Schutzschicht in einem kontinuierlichen Rolle-zu-Rolle-Verfahren zur Herstellung eines Halbfabrikats organischer elektronischer Bauelemente, umfassend einen Schichtstapel auf einer Substratfolie. Dabei schützt die Schutzschicht den Schichtstapel vor und während der Endfertigung vor Umwelteinflüssen und durch die Handhabung bedingten Beschädigungen. Der besondere Vorzug besteht darin, dass für die vollständige Produktion mehrere, aufeinanderfolgende Rolle-zu-Rolle-Anlagen verwendet werden können, betrieben je nach Anforderung unter atmosphärischen, inerten oder Niederdruckbedingungen. Damit wird die Komplexität und Größe der Einzelanlagen verringert. So ist es beispielsweise sinnvoll eine Rolle-zu-Rolle-Anlage zur Herstellung der organischen Bauelemente zu verwenden und eine weitere Anlage zur weiterführenden Verkapselung dieser, da die Prozessumgebung dieser beiden Produktionsschritte maßgeblich voneinander verschieden sein kann. Die prozesstechnische Trennung geschieht hierbei beispielsweise nach der vollständigen Abscheidung und Strukturierung der funktionalen organischen Bauelemente. Die bereits gefertigten Schichten werden durch die erfindungsgemäße Schutzschicht zwischen den Arbeitsschritten vor Lösungsmitteln und/oder mechanischem Stress bewahrt. Hinzu kommt, dass Schäden an dem organischen Schichtstapel, die durch die fertigungsbedingt geringe Haftung zwischen organischem Schichtstapel und Elektrode bei Auf- und Abwicklung des fortlaufenden Substrates hervorgerufen werden können, vermieden werden, weil die Schutzschicht ein Ablösen verhindert oder erschwert. Im Sinne des erfindungsgemäßen Verfahrens ist es zudem vorgesehen, dass die funktionelle Schutzschicht eines der Materialien umfasst, das die zuvor genannten Anforderungen erfüllt.

Eine weitere Funktion der Schutzschicht ist das komplette Einbetten von Partikeln und Materialaufwürfen der Laserstrukturierung, zur Vermeidung von Kurzschlusspfaden durch Eindrücken dieser in darunterliegenden organischen Schichtstapel.

In einer Ausführungsform der Erfindung deckt die erfindungsgemäße Schutzschicht dabei den kompletten organischen Schichtstapel ab.

Erfindungsgemäß deckt die Schutzschicht den Bereich des busbars und/oder der Kontakte nicht ab.

Sinnvoll ist ebenfalls, wenn vor dem Aufrollen des Halbfabrikats eine Zusatzschicht aufgebracht wird, welche trotz längerer Lagerzeiten in einem großen Rollenwickel eine Anhaftung der gegen die Zusatzschicht gewickelten Substratunterseite des Halbfabrikatrolle verhindert.

Diese Zusatzschicht kann sowohl permanent als auch temporär aufgebracht werden. Unter "temporär" wird erfindungsgemäß verstanden, wenn diese Zusatzschicht bei einer weiteren Verarbeitung des Halbfabrikats rückstandlos entfernt werden kann und dabei durch das Entfernen der Zusatzschicht keine Beschädigungen an den Funktionsschichten des Stacks und/oder der Schutzschicht hervorgerufen werden.

Als temporäre Zusatzschicht kann beispielsweise eine Folie verwendet werden. Alternativ kann auch ein Lack, als permanente Zusatzschicht, ein Material, ausgewählt aus den Materialien der Schutzschicht, oder sonstige transparente Materialien mit einer geringen Affinität zur Polymersubstratfolie, aufgebracht werden.

### Halbfabrikat mit Schutzschicht

Das Halbfabrikat stellt ein organisches elektronisches Rolle-zu-Rolle Halbfabrikat auf einem fortlaufenden Substrat mit mindestens einem optoelektronischen Bauelement dar, umfassend ein Substrat, eine auf dem Substrat angeordnete Elektrode, einen organischen Schichtstapel und eine Gegenelektrode auf der dem Substrat abgewandten Seite des Schichtstapels, mindestens eine photoaktive organische Schicht zwischen der Elektrode und der Gegenelektrode, und eine Schutzschicht auf der dem Substrat abgewandten Seite des mindestens einen optoelektronischen Bauelements, wobei die Schutzschicht den organischen Schichtstapel komplett bedeckt, aus einer lösungsmittelfreien auf Silikon basierten Komposition besteht, welche sowohl klar sein muss, also im sichtbaren Spektralbereich weitestgehend transparent, als auch Füllstoffe enthalten kann, und mittels UV-, Elektronen-Bestrahlung oder thermisch verlinkt wird, elektrisch isolierend ist und in einem fortlaufenden Prozess abgeschieden wird, beispielsweise gedruckt wird, auch im Vakuum.

Eine besonders bevorzugte Ausführungsform umfasst als zu schützenden Schichtstapel, ein optoelektronisches Bauelement, vorzugsweise eine organisches optoelektronisches Bauelement, umfassend mindestens zwei Elektroden, wobei eine Elektrode auf dem Substrat, das eine Barrierefunktion gegen Wasserdampf, Sauerstoff oder Wasser umfassen kann, aufgebracht ist und die andere als Gegenelektrode auf der vom Substrat abgewandten Seite aufgebracht ist, weiterhin umfassend mindestens eine photoaktive Schicht zwischen den Elektroden. Bevorzugt wird der zu schützende Schichtstapel überwiegend durch Verdampfen oder Sublimieren kleiner Moleküle mit oder ohne Trägergas auf einem Substrat hergestellt. Der zu schützende Schichtstapel kann noch weitere funktionale Schichten, beispielsweise Transport- oder Passivierungsschichten, umfassen.

Die Erfindung betrifft ein in die Rolle-zu-Rolle-Produktion eines solchen organisch-elektronischen Halbfabrikats integrierbares Verfahren, um diese Schutzschicht aufzubringen. Im Anschluss an das kontinuierliche Rolle-zu-Rolle-Verfahren kann ein Transfer in eine Folgemaschine erfolgen, in der weitere Bearbeitungsschritte vollzogen werden. Dann liegt nach Abschluss des Rolle-zu-Rolle-Verfahrens nur ein Halbfabrikat vor, beispielsweise bestehend aus mindestens drei aufeinander folgenden organischen elektronischen photovoltaischen und/oder elektrochromen Modulen, welche auf einem flexiblen Substrat wie beispielsweise PET-Folie im Rolle-zu-Rolle- Verfahren hergestellt wurden. Für die weiteren Bearbeitungsschritte können neben der gesamten Rolle auch Abschnitte des Halbzeugs in geeigneter Länge verwendet werden.

Die Schutzschicht, das erfindungsgemäße Rolle-zu-Rolle Produktionsverfahren als auch das Halbfabrikat sind ebenso auf weitere organische halbleitende Bauelemente und deren Verfahren zur Herstellung in einem Rolle-zu-Rolle Verfahren übertragbar.

Bevorzugt sind die wesentlichen Merkmale der verwendbaren Polymerzusammensetzung diese, dass sie keine Schädigung der organischen Schichten hervorruft, wie oben bereits beschrieben.

### Kurze Beschreibung der Zeichnungen

Weitere Einzelheiten, Merkmale und Vorteile der Erfindung ergeben sich aus der nachfolgenden Beschreibung von Ausführungsbeispielen mit Bezugnahme auf die zugehörigen Zeichnungen. Es zeigen:
Fig. 1: schematisch eine Ausführungsform eines Halbfabrikats in Schnittdarstellung;
Fig. 2: schematisch eine Ausführungsform einer Anlage zur Herstellung eines Halbfabrikat im Rolle-zu-Rolle-Verfahren;
Fig. 3: schematisch eine Ausgestaltung des erfindungsgemäßen Verfahrens mit Auftrag des Schutzschichtmaterials durch eine Druckeinrichtung und nachfolgender Vernetzung;
Fig. 4: schematisch eine Ausgestaltung des erfindungsgemäßen Verfahrens, wobei eine besondere Topographie erzielt wird;
Fig. 5: schematisch ein Halbfabrikat, bei dem die Schutzschicht Unterbrechungen für eine elektrische Kontaktierung aufweist;
Fig. 6: schematisch das Aufbringen einer Zusatzschicht zwischen Schichtstapel und Schutzschicht zum Einfügen weiterer Zusatzfunktionen in das Halbfabrikat oder zur Verbesserung der Haftung der Schutzschicht auf dem Schichtstapel;
Fig. 7: schematisch das Aufbringen einer Zusatzschicht auf der Schutzschicht zur Verringerung ungewollter Beschädigung bei dem Auf- und Abrollen des Halbfabrikats;
Fig. 8: schematisch eine Kombination von Fig. 6 und Fig. 7
Fig. 9 und Fig. 10: schematisch das Aufbringen einer Schutzschicht ohne bzw. unter Einbeziehung der busbars;
Fig. 11: schematisch eine Variante des Aufbringens einer temporären Zusatzschicht auf der Schutzschicht;
Fig. 12 und Fig. 13: Rasterelektronenmikroskop-Aufnahmen von aufgebrachten Schutzmaterialien auf Schichtstapeln mit laserprozessierten Elektroden;
Fig. 14: schematisch den Vergleich zwischen Höhenausgleich und Glätten durch die aufgebrachte Schutzschicht auf einem Schichtstapel

### Beschreibung der Ausführungsformen

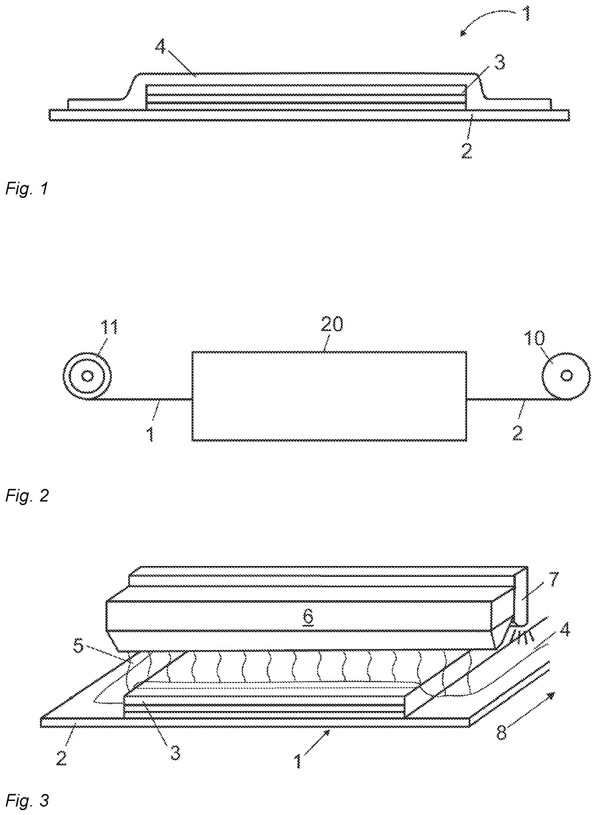

Fig. 1 zeigt schematisch eine Ausführungsform eines Halbfabrikats 1 in Schnittdarstellung, wobei ein Substrat 2 erkennbar ist, auf dem ein Schichtstapel 3, der ein organisches elektronisches Bauelement bildet, aufgebaut ist. Beides ist mit der Schutzschicht 4 überdeckt.

Hierbei wird erkennbar, dass bereits ohne weiteres die Schutzschicht 4 Vorteile gegenüber der herkömmlichen, als eine gesonderte Folie aufgebrachten Schutzschicht aufweist. So sind die Ränder des Schichtstapels 3 vollständig von der Schutzschicht 4 umschlossen, da diese auch den Rand der Schichtstapels 3 umfließt. Dies sorgt für einen besseren Halt des Schichtstapels 3 auf dem Substrat 2 und verhindert ein Ablösen des Schichtstapels 3 von dem Substrat 2, beispielsweise beim Auf- und Abrollen.

Fig. 2 zeigt schematisch eine Ausführungsform einer Anlage zur Herstellung eines Halbfabrikats 1 im Rolle-zu-Rolle-Verfahren. Dabei ist das Substrat 2 auf eine Rolle 10 aufgerollt und läuft dadurch quasikontinuierlich in die geschlossene Anlage 20 ein. Dort wird entsprechend der technologischen Vorgaben und unter den erforderlichen Bedingungen der Schichtstapel zur Herstellung des elektronischen Bauelementes gebildet. Bevorzugt erfolgt die Fertigung des Schichtstapels 3 unter Vakuum, so dass in der Anlage 20 ein sehr niedriger Druck herrscht.

Das so geschaffene Halbfabrikat 1 wird auf die Rolle 11 aufgewickelt. So kann das Halbfabrikat 1 der weiteren, gegebenenfalls abschnittsweise unterschiedlichen Bearbeitung zugeführt werden. Wegen der vorhandenen Schutzschicht, wie sie die Erfindung vorsieht, wird das Halbfabrikat 1 weder durch das Aufrollen auf die Rolle 11, noch durch Berührung der Oberflächen beschädigt. Beides verhindert die Schutzschicht auf dem Halbfabrikat 1.

Fig. 3 zeigt schematisch eine Ausgestaltung des erfindungsgemäßen Verfahrens mit Auftrag des Schutzschichtmaterials 5 durch eine Druckeinrichtung 6 und nachfolgender Vernetzung zur Erzeugung eines Halbfabrikats 1. Die Druckeinrichtung 6 ist besonders bevorzugt als Breitschlitzdüse ausgeführt, so wie hier dargestellt. Hierbei bewegt sich die Substratfolie 2 mit dem zuvor gebildeten Schichtstapel 3 in Vorschubrichtung 8 unter der Druckeinrichtung 6 hindurch. Währenddessen gibt die Druckeinrichtung 6 kontinuierlich einen Schwall Schutzschichtmaterial 5 über die gesamte Bearbeitungsbreite ab, der dadurch die Substratfolie 2 mit dem Schichtstapel 3 überzieht.

Dadurch kann auf der gesamten zu schützenden Breite des Substrats 2 das Schutzschichtmaterial 5 aufgebracht werden kann. Dies sorgt für eine effiziente Prozessführung, hohe Produktivität und eine gleichmäßige Ausbildung der Schutzschicht 4.

Damit das flüssige, beispielsweise monomere Schutzschichtmaterial 5 eine feste Schutzschicht 4 bildet, ist zum Aushärten eine Vernetzung erforderlich. Diese wird nach der bevorzugten Ausgestaltung des Verfahrens mittels UV-Strahlung hervorgerufen, die eine Vernetzungseinrichtung 7 abgibt, wenn es sich bei dem Schutzschichtmaterial 5 um ein durch UV-Strahlung vernetzbares Polymermaterial handelt, was bevorzugt zum Einsatz kommt. Die Vernetzungseinrichtung 7 ist benachbart zu der Druckeinrichtung 6 angeordnet.

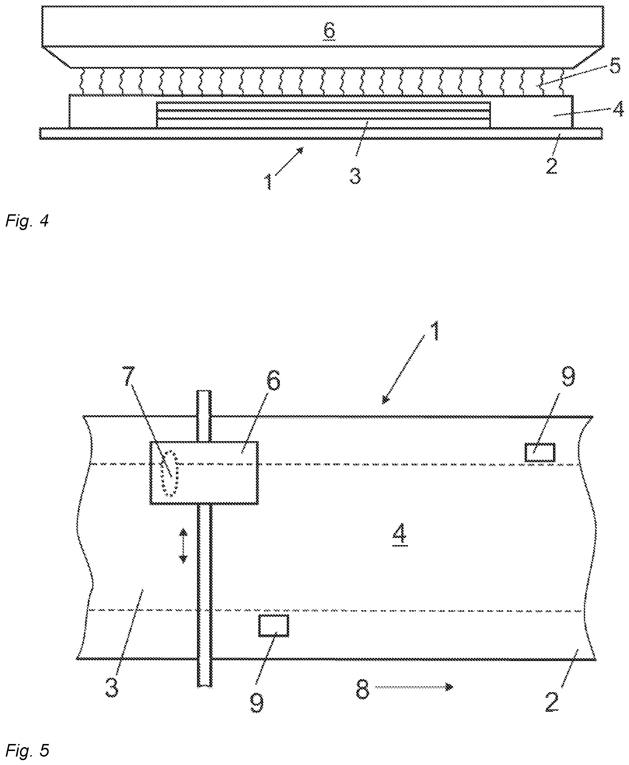

Hier wird als eine Ausführungsform eines nicht-erfindungsgemäßen Verfahrens die gesamte Breite der entstehenden Schutzschicht gleichzeitig belichtet. Erfindungsgemäß erfolgt die Vernetzung selektiv, so dass Kontaktbereiche unvernetzt bleiben. Dies kann z.B. durch Auslassungen erreicht werden, welche durch eine quer zur Vorschubrichtung 8 bewegliche Vernetzungseinrichtung 7 oder durch die separate Ansteuerbarkeit einzelner UV-Lichtquellen auf der leistenförmigen Vernetzungseinrichtung 7 hergestellt werden. Fig. 4 zeigt schematisch eine Ausgestaltung des erfindungsgemäßen Verfahrens, wobei eine besondere Topographie erzielt wird. Über den Schichtstapel 3 wird eine Schutzschicht 4 mithilfe der Druckeinrichtung 6, die das Schutzschichtmaterial 5 aufträgt, in ausreichender Dicke aufgebracht. Die Aushärtung erfolgt wiederum mit der Vernetzungseinrichtung, die hier nicht sichtbar ist.

Die Besonderheit besteht vorliegend aber darin, dass über dem Substrat 2, wo also kein Schichtstapel 3 vorhanden ist, das Schutzschichtmaterial in einer solchen Menge und Stärke aufgebracht wird, dass die Höhendifferenz ausgeglichen wird. Im Ergebnis entsteht eine gleichmäßige, ebene Oberfläche der Schutzschicht 4, ungeachtet dessen, ob sich nur das Substrat 2 oder der Schichtstapel 3 unter der Schutzschicht befindet.

Nach der dargestellten Ausführungsform der Druckeinrichtung 6, einer Breitschlitzdüse, muss der Schlitz entsprechend modifiziert und inhomogen sein, damit er in einem mittleren Bereich eine dünnere Schutzschicht 4 hervorruft, hingegen in den Randbereichen dickere Schutzschichten 4 hinterlässt. Ein gute Möglichkeit, um eine solche oder eine andersartige inhomogene Topografie zu erreichen, bietet auch die Ausführungsform der Druckeinrichtung 6 als Druckkopf, wie sie in der nachfolgenden Fig. 5 dargestellt ist.

Fig. 5 zeigt schematisch ein Halbfabrikat 1, das in Vorschubrichtung 8 durch eine Fertigungsanlage geführt wird und bei dem die Schutzschicht 4 Unterbrechungen aufweist, die elektrische Kontaktierungsstellen 9 dienen, indem dort eine leitfähige Verbindung zur späteren Kontaktierung des fertigen Bauelements hergestellt werden kann. Die Herstellung der Schutzschicht 4 erfolgt mittels eines Druckkopfes, der die Druckeinrichtung 6 bildet. Dieser bewegt sich quer zur Vorschubrichtung 8 des Substrats 2.

Dabei kann die Druckeinrichtung 6 nicht nur eine Topographie ähnlich der in Fig. 4 dargestellten hervorrufen, sondern auch einzelne Stellen, wie zum Beispiel die Kontaktierungsstelle 9, von der Beschichtung mit dem Schutzschichtmaterial ausnehmen. Bei der bevorzugten Ausgestaltung weist die Druckeinrichtung 6 zugleich die Vernetzungseinrichtung 7 auf, so dass Auftrag und Vernetzung der Schutzschicht 4 in einem Arbeitsgang erfolgen können.

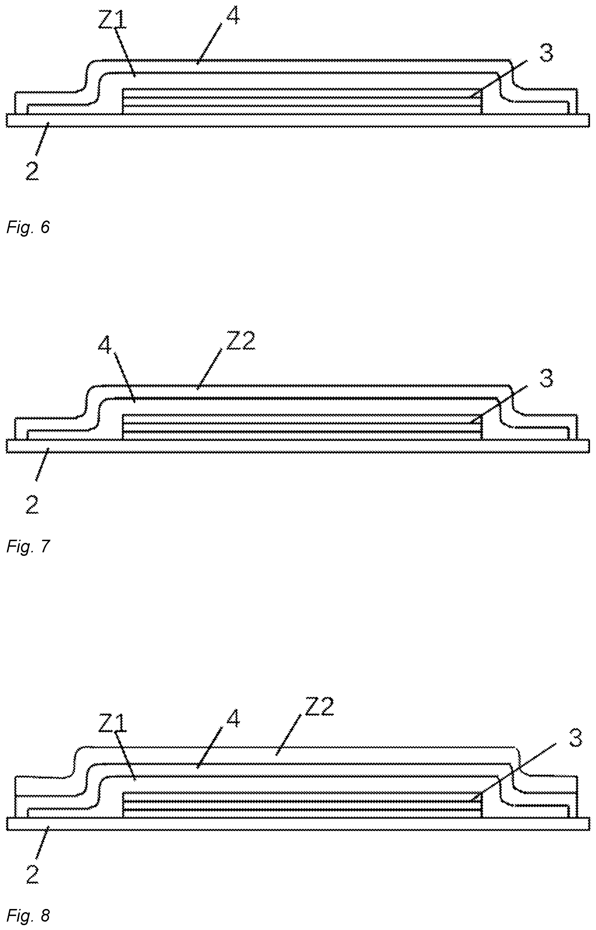

Fig. 6 zeigt schematisch eine Ausführungsform eines Halbfabrikats 1 in Schnittdarstellung, wobei ein Substrat 2 erkennbar ist, auf dem ein Schichtstapel 3, der ein organisches elektronisches Bauelement bildet, aufgebaut ist und eine Zusatzschicht Z1 umfasst. Alles ist mit der Schutzschicht 4 überdeckt. Die Zusatzschicht Z1 erfüllt eine zusätzliche Funktion außerhalb der elektrischen Funktionalität des elektronischen Bauelements, z.B. Getterwirkung, Lichteinkopplung oder eine Haftvermittlung zwischen Elektrode und Schutzschicht 4.

Fig. 7 zeigt schematisch eine Ausführungsform eines Halbfabrikats 1 in Schnittdarstellung, wobei ein Substrat 2 erkennbar ist, auf dem ein Schichtstapel 3, der ein organisches elektronisches Bauelement bildet, aufgebaut ist. Beides ist mit der Schutzschicht 4 überdeckt, welche wiederum von einer Zusatzschicht Z2 überdeckt ist, welche eine zusätzliche Funktion zur Ergänzung der Eigenschaft der Schutzschicht besitzt, z.B. zur Haftvermittlung für einen darauffolgenden Laminationsprozess einer Barrierefolie bzw. der Abscheidung von Verkapselungsschichten zur Fertigstellung des Halbfabrikats oder einer Antihaft-Schicht zur Verbesserung der Auf- und Abwicklung des Halbfabrikates bzw. der Lagerung des Halbfabrikates im aufgewickelten Zustand. Die Zusatzschicht Z2 kann je nach Ausführung sowohl eine abgeschiedene Schicht oder auch eine temporäre Trennfolie 401 darstellen.

Fig. 8 zeigt eine schematische Ausführung eines Halbfabrikats 1 in Schnittdarstellung, wobei ein Substrat 2 erkennbar ist, auf dem ein Schichtstapel 3, der ein organisches elektronisches Bauelement bildet, aufgebaut ist und eine Zusatzschicht Z1. Alles ist mit der Schutzschicht 4 überdeckt, welche wiederum von einer Zusatzschicht Z2 überdeckt ist. Die Eigenschaften der Zusatzschichten Z1 und Z2 sind beispielhaft in der Erläuterung von Fig. 6 und Fig. 7 beschrieben.

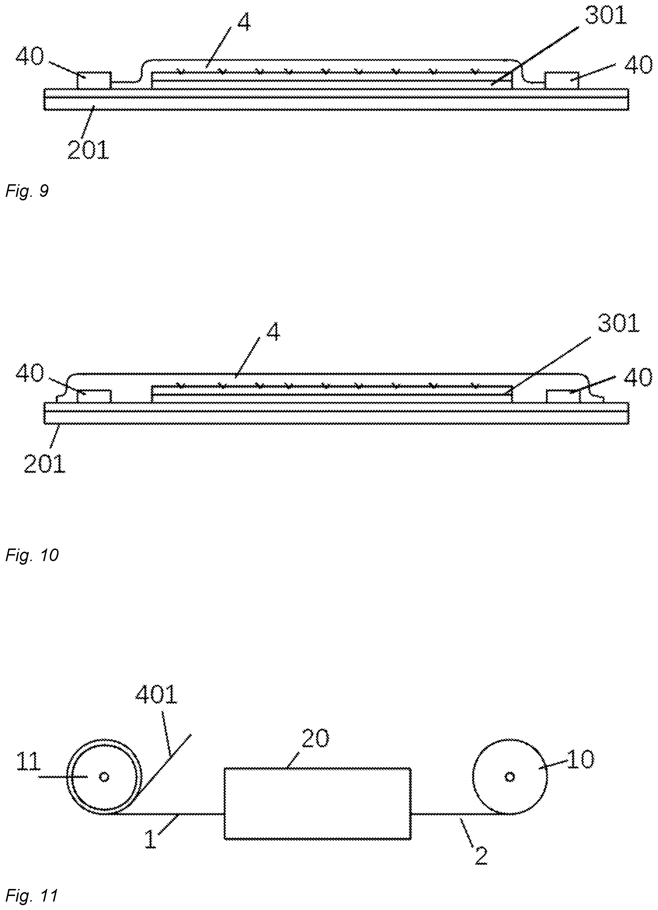

Fig. 9 zeigt schematisch eine Ausführungsform eines Halbfabrikats 1 in Schnittdarstellung, wobei ein Substrat mit leitfähiger Elektrode 201 erkennbar ist, auf dem ein mit Hilfe von Lasern strukturierter Schichtstapel 301 (die Laserstrukturierungen sind mit kleinen "v" auf der Oberfläche des Schichtstapels angedeutet), der ein organisches elektronisches Bauelement bildet, aufgebaut ist, auf dessen Oberfläche aufgrund der Laserstrukturierung und anderer Prozesseigenschaften Materialaufwürfe und/oder Partikel vorhanden sind. Zudem ist ein busbar 40 für die Kontaktierung des organischen elektronischen Bauelementes aufgebracht. Die Schutzschicht 4 ist in diesem Falle so aufgebracht, dass mindestens der funktionale und strukturierte organische Bereich des Halbfabrikates bedeckt ist.

Fig. 10 zeigt schematisch eine Ausführungsform eines Halbfabrikats 1 in Schnittdarstellung, wobei ein Substrat mit optionaler Barriere und mit leitfähiger Elektrode 201 erkennbar ist, auf dem ein mit Hilfe von Lasern strukturierter Schichtstapel 301, der ein organisches elektronisches Bauelement bildet, aufgebaut ist, auf dessen Oberfläche aufgrund der Laserstrukturierung und anderer Prozesseigenschaften Materialaufwürfe und/oder Partikel vorhanden sind. Zudem ist eine busbar 40 für die Kontaktierung des organischen elektronischen Bauelementes aufgebracht. Die Schutzschicht 4 ist in diesem Falle so aufgebracht, dass sowohl der funktionale organische Bereich als auch die busbar bedeckt ist. Gemäß Fig. 5 können einzelne Bereiche auf der busbar zur späteren Kontaktierung frei gehalten werden.

Fig. 11 zeigt schematisch eine weitere Ausführungsform einer Anlage zur Herstellung eines Halbfabrikats 1 im Rolle-zu-Rolle-Verfahren gemäß Fig. 2. Das in der Anlage 20 geschaffene Halbfabrikat 1 wird in diesem Ausführungsbeispiel zusammen mit einer Zusatzschicht Z2, welche in diesem Fall aus einer separaten Folie 401 gebildet wird, aufgewickelt.

Fig. 12 zeigt eine Rasterelektronenmikroskopieaufnahme eines Halbfabrikats gemäß Fig. 9. Zu sehen ist ein Ausschnitt mit einer laserstrukturierten Elektrodenschicht. Durch den Eintrag hoher Energien zur Auftrennung der Elektrode wird diese etwas aufgebogen. Man kann erkennen, dass die Schutzschicht 4 perfekt um die abstehende Elektrodenkante geflossen ist und die darauffolgende Vernetzung zu einer Fixierung des Elektrodenaufwurfes führt. Dem Fachmann ist ersichtlich, dass das Einbetten der Aufwürfe in eine zunächst flüssige Schutzschicht 4 vorteilhaft gegenüber der Verwendung einer Polymerfolie gemäß dem Stand der Technik ist, da bei dieser die Gefahr besteht, dass die Aufwürfe gegen den organischen Schichtstapel gepresst werden und so zu unerwünschten Kurzschlusspfaden führen.

Fig. 13 zeigt eine weitere Rasterelektronenmikroskopieaufnahme eines Halbfabrikats gemäß Fig. 9. Zu sehen ist erneut ein Ausschnitt mit einer laserstrukturierten Elektrodenschicht. Durch den Eintrag hoher Energien zur Auftrennung der Elektrode wird diese etwas aufgebogen. Zudem ist ein irgendwo aus dem Laserkanal herausgetrenntes Stück der Elektrode auf dem Bauelement verblieben. Man kann erkennen, dass die Schutzschicht 4 erneut perfekt um die abstehende Elektrodenkante geflossen ist und zudem das herausgelöste jedoch auf dem Bauelement verblieben Elektrodenstück fixiert. Der Vorteil der Verwendung einer im Vergleich zum Schichtstapel des organischen elektronischen Bauelementes sehr dicken und zunächst fluiden Schutzschicht ist auch in diesem Falle dem Fachmann sofort ersichtlich. Bei der weiteren Verarbeitung lässt sich eine auf diese Art und Weise geglättete Oberfläche wesentlich gutmütiger Behandeln und verringert die technologische Herausforderung für die nachfolgenden Prozesse wesentlich.

Fig. 14 verdeutlicht die beiden Eigenschaften Höhenausgleich und Glätten des Schichtstapels. Deutlich zu erkennen ist, in beiden Abbildungen ein Substrat 2 auf den ein Schichtstapel 3 angeordnet ist der mit einer Schutzschicht 4 bedeckt ist. Beim Höhenausgleich a) erhält man klar erkennbar ein planares Halbfabrikat mit Schutzschicht. Im Gegensatz dazu ist beim Glätten b) etwa eine gleichdicke Schutzschicht aufgetragen, so dass alle Unebenheiten abgedeckt sind.

### Bezugszeichenliste

- 1: Halbfabrikat
- 2: Substrat / Substratfolie mit optionaler Barrierefunktion
- 201: Substrat mit optionaler Barrierefunktion und mit leitfähiger Elektrode
- 3: Schichtstapel
- 301: laser-strukturierter Schichtstapel mit Material-Aufwürfen
- 4: Schutzschicht
- 401: temporärer Schutzfilm
- Z1: Zusatzschicht 1
- Z2: Zusatzschicht 2
- 5: Schutzschichtmaterial
- 6: Druckeinrichtung
- 7: Vernetzungseinrichtung
- 8: Vorschubrichtung
- 9: Kontaktierungsstelle
- 10: Rolle (Substrat)
- 11: Rolle (Halbfabrikat)
- 20: Anlage
- 40: busbar

## Patentansprüche

1. Verfahren zum Aufbringen einer Wickelschutzschicht (4) für die Herstellung eines Halbfabrikats (1) organischer elektronischer Bauelemente, umfassend einen Schichtstapel (3) auf einer Substratfolie (2) optional mit Barrierefunktion, wobei die Wickelschutzschicht (4) den Schichtstapel (3) vor und während der Endfertigung des Halbfabrikats vor Umwelteinflüssen und durch die Handhabung bedingte Beschädigungen schützt, wobei das Verfahren ein kontinuierliches Rolle-zu-Rolle-Verfahren im Vakuum ist, welches folgende Schritte umfasst:
- Auftrag eines wasser- und lösungsmittelfreien, zumindest temporär in der Phase des Auftrags fluiden, vernetz- oder aushärtbaren, mit dem Schichtstapel (3) in fluider und in fester Phase sowie mit den Bedingungen während des Rolle-zu-Rolle-Verfahrens kompatiblen Schutzschichtmaterials (5) mittels eines Druckverfahrens, welches wenigstens eines der Verfahren Siebdruck, Flexoprint, Plotten, Tintenstrahldruck, Schlitzdüsendruck oder ein zum 3D-Druck geeignetes Verfahren umfasst,
- Vernetzung oder Aushärtung des Schutzschichtmaterials (5) durch wenigstens eines der Verfahren UV-Vernetzung, thermische Vernetzung, Abkühlung oder Trocknung,
wobei das Schutzschichtmaterial (5) im flüssigen Zustand wasser- und lösungsmittelfrei ist , **dadurch gekennzeichnet, dass** das Schutzschichtmaterial einen Dampfdruck aufweist, der unter dem beim Herstellungsverfahren vorgesehenen Umgebungsdruck liegt, und
beim Druckverfahren Bereiche der Kontakte und/oder der Busbars von Schutzschichtmaterial (5) freigehalten werden, und/oder die Vernetzung durch UV-Vernetzung oder eine andere Strahlungsquelle selektiv erfolgt, so dass Kontaktbereiche unvernetzt bleiben und leicht abgewischt, abgespült oder sonst wie von dem flüssigen Schutzschichtmaterial (5) befreit werden können, während die übrigen Bereiche bereits vernetzt und fest mit dem Untergrund verbunden sind.

2. Verfahren nach Anspruch 1, wobei das Schutzschichtmaterial (5) in der Phase des Auftrags eine Viskosität von maximal 10000 mPa.s aufweist.

3. Verfahren nach Anspruch 1 oder 2, wobei das Schutzschichtmaterial (5) eine Mindestviskosität von etwa 10 mPa.s, bevorzugt von ca. 10² mPa.s aufweist.

4. Verfahren nach einem der vorhergehenden Ansprüche, wobei die funktionelle Wickelschutzschicht (4) mit einer Dicke von mindestens 50 nm und höchstens 200 µm hergestellt wird.

5. Verfahren nach einem der vorhergehenden Ansprüche, wobei die funktionelle Wickelschutzschicht (4) mit einer Dicke von mindestens 5 µm und höchstens 100 µm hergestellt wird.

6. Verfahren nach einem der vorhergehenden Ansprüche, wobei die Wickelschutzschicht (4) eine bestimmte Strukturierung erhält.

7. Verfahren nach Anspruch 1, wobei wenigstens eine der Materialgruppen Thermoplaste, Duroplaste oder Elastomere als Schutzschichtmaterial (5) vorgesehen ist.

8. Verfahren nach Anspruch 1, wobei wenigstens eine der Materialgruppen Phenoplaste, Aminoplaste, ungesättigte Polyester-Harze, Vinylester-Harze, Epoxid-Harze, Silicon-Harze, Dicyclopentadien, oder Diallylphthalat-Harze als Schutzschichtmaterial (5) vorgesehen ist.

9. Verfahren nach Anspruch 1, wobei als Schutzschichtmaterial (5) aromatische, aliphatische, halogenfreie oder halogenhaltige Polyolefine; aromatische, aliphatische, gesättigte oder ungesättigte Polyester; Polyamide, Epoxysiloxane, Polyurethane, Phenolformaldehydharze oder Poly(organo)siloxane vorgesehen sind.

10. Verfahren nach einem der Ansprüche 1, 7-9, wobei eine Kombination mehrerer Materialien der in einem der Ansprüche 7 bis 9 genannten Materialgruppen als Schutzschichtmaterial (5) verwendet werden.

11. Verfahren nach einem der vorhergehenden Ansprüche, **dadurch gekennzeichnet, dass** nach dem Aufbringen der funktionellen Wickelschutzschicht (4), eine Zusatzschicht (Z2) auf die funktionelle Wickelschutzschicht (4) aufgebracht wird, so dass die funktionelle Wickelschutzschicht (4) bei der weiteren Bearbeitung des Halbfabrikats sich nicht von dem Schichtstapel (3) löst.

12. Verfahren nach Anspruch 11, wobei das Material der Zusatzschicht (Z2) aus den Materialgruppen entsprechend dem Schutzschichtmaterial (5) ausgewählt ist.

13. Verfahren nach Anspruch 11, wobei das Material der Zusatzschicht (Z2) als transparentes oder halbtransparentes Material aufgebracht wird.

14. Verfahren nach Anspruch 11, wobei die Zusatzschicht (Z2) als temporärer Film (401) aufgebracht wird, und vor dem Weiterverarbeiten zu einem späteren Zustand wieder rückstandsfrei entfernt werden kann, wobei der Schichtstapel (3) beim Abwickeln nicht beschädigt wird.

15. Verfahren nach einem der vorherigen Ansprüche, wobei die funktionelle Wickelschutzschicht (4) zumindest eine der Zusatzfunktionen Höhenausgleich mit dem Schichtstapel (3), Glätten des Schichtstapels (3), verbesserte Haftung einer Verkapselung und Freihalten von Kontaktierungsstellen (9) ausfüllt oder beigemischtes oder in einem vorhergehenden Verfahrensschritt zumindest auf den Schichtstapel (3) aufgetragenes Gettermaterial aufweist.

16. Verfahren nach einem der vorherigen Ansprüche, wobei das Halbfabrikat (1) ein organisches optoelektronisches Bauelement ist.

17. Verfahren nach Anspruch 16, wobei das Halbfabrikat (1) ein organisches optoelektronisches Bauelement ist, vorzugsweise ein organisches photoaktives Bauelement, mit einem aus mehreren Schichten bestehenden Schichtstapel (3), wobei mindestens die photoaktive Schicht bzw. die photoaktiven Schichten teilweise oder vollständig aus kleinen organischen Molekülen bestehen, die vorzugsweise durch Verdampfen aufgebracht sind.

18. Verfahren nach Anspruch 16, wobei die funktionelle Wickelschutzschicht (4) als Zusatzfunktionen eine Vorbereitung von nach der Verkapselung wirksamen optischen Effekten umfasst.

## Claims

1. Process for applying a winding protection layer (4) for producing a semi-finished product (1) of organic electronic components, comprising a layer stack (3) on a substrate foil (2) optionally with barrier function, where the winding protection layer (4) protects the layer stack (3) before and during the final manufacture of the semi-finished product from environmental effects and damage due to handling, where the process is a continuous roll-to-roll process under reduced pressure, which comprises the following steps:
- applying a water-free and solvent-free, crosslinkable or curable protection layer material (5) which is fluid at least temporarily in the application phase and is compatible with the layer stack (3) in fluid and in solid phase and also with the conditions during the roll-to-roll process, by means of a printing process which comprises at least one of the processes composed of screen printing, flexographic printing, plotting, inkjet printing, slot die printing or a process suitable for 3D printing,
- crosslinking or curing the protection layer material (5) by at least one of the processes composed of UV crosslinking, thermal crosslinking, cooling or drying,
where the protection layer material (5) in the liquid state is water-free and solvent-free, **characterized in that** the protection layer material has a vapour pressure which is below the ambient pressure envisaged in the production process, and in the printing process, regions of the contacts and/or of the busbars are kept clear of protection layer material (5), and/or the crosslinking by UV crosslinking or other radiation source takes place selectively, so that contact regions remain uncrosslinked and can be easily wiped, rinsed or otherwise freed from the liquid protection layer material (5), while the remaining regions are already crosslinked and joined firmly to the base.

2. Process according to Claim 1, where the protection layer material (5) in the application phase has a viscosity of not more than 10 000 mPa.s.

3. Process according to Claim 1 or 2, where the protection layer material (5) has a minimum viscosity of about 10 mPa.s, preferably of around 10² mPa.s.

4. Process according to any of the preceding claims, where the functional winding protection layer (4) is produced with a thickness of at least 50 nm and at most 200 µm.

5. Process according to any of the preceding claims, where the functional winding protection layer (4) is produced with a thickness of at least 5 µm and at most 100 µm.

6. Process according to any of the preceding claims, where the winding protection layer (4) receives a defined patterning.

7. Process according to Claim 1, where at least one of the groups of materials composed of thermoplastics, thermosets or elastomers is provided as protection layer material (5).

8. Process according to Claim 1, where at least one of the groups of materials composed of phenolic resins, amino resins, unsaturated polyester resins, vinyl ester resins, epoxy resins, silicone resins, dicyclopentadiene, or diallyl phthalate resins is provided as protection layer material (5) .

9. Process according to Claim 1, where aromatic, aliphatic, halogen-free or halogen-containing polyolefins; aromatic, aliphatic, saturated or unsaturated polyesters; polyamides, epoxysiloxanes, polyurethanes, phenol-formaldehyde resins or poly(organo)siloxanes are provided as protection layer material (5).

10. Process according to any of Claims 1 and 7-9, where two or more materials from the groups of materials stated in any of Claims 7 to 9 are used in combination as protection layer material (5).

11. Process according to any of the preceding claims, **characterized in that** after the application of the functional winding protection layer (4), an additional layer (Z2) is applied to the functional winding protection layer (4), so that in the further working of the semi-finished product the functional winding protection layer (4) does not part from the layer stack (3).

12. Process according to Claim 11, where the material of the additional layer (Z2) is selected from the groups of materials corresponding to the protection layer material (5).

13. Process according to Claim 11, where the material of the additional layer (Z2) is applied as transparent or semi-transparent material.

14. Process according to Claim 11, where the additional layer (Z2) is applied as a temporary film (401), and may be removed again without residue prior to further processing at a later stage, with the layer stack (3) not being damaged during unwinding.

15. Process according to any of the preceding claims, where the functional winding protection layer (4) fulfils at least one of the additional functions of height compensation with the layer stack (3), smoothing of the layer stack (3), improved adhesion of an encapsulation and the keeping-clear of contacting points (9), or comprises getter material which is admixed or is applied at least to the layer stack (3) in a preceding process step.

16. Process according to any of the preceding claims, where the semi-finished product (1) is an organic optoelectronic component.

17. Process according to Claim 16, where the semi-finished product (1) is an organic optoelectronic component, preferably an organic photoactive component, having a layer stack (3) consisting of two or more layers, where at least the photoactive layer or the photoactive layers consist partly or entirely of small organic molecules which are applied preferably by vapour deposition.

18. Process according to Claim 16, where the functional winding protection layer (4) comprises as additional functions a preparation of optical effects which are active after the encapsulation.

## Revendications

1. Procédé d'application d'une couche de protection d'enroulement (4) pour la fabrication d'un produit semi-fini (1) de composants électroniques organiques, comprenant un empilement de couches (3) sur un film de substrat (2) ayant éventuellement une fonction de barrière, la couche de protection d'enroulement (4) protégeant l'empilement de couches (3) avant et pendant la fabrication finale du produit semi-fini des influences de l'environnement et des détériorations dues à la manipulation, le procédé étant un procédé continu de rouleau à rouleau sous vide, qui comprend les étapes suivantes:
- l'application d'un matériau de couche de protection (5) exempt d'eau et de solvant, au moins temporairement fluide dans la phase de l'application, réticulable ou durcissable, compatible avec l'empilement de couches (3) en phase fluide et en phase solide, ainsi qu'avec les conditions pendant le procédé de rouleau à rouleau, au moyen d'un procédé d'impression, qui comprend au moins l'un des procédés parmi la sérigraphie, la flexographie, le traçage, l'impression à jet d'encre, l'impression à buse à dente ou un procédé adapté à l'impression 3D,
- la réticulation ou le durcissement du matériau de couche de protection (5) par au moins l'un des procédés parmi la réticulation par UV, la réticulation thermique, le refroidissement ou le séchage,
dans lequel le matériau de couche de protection (5) est exempt d'eau et de solvant à l'état liquide, **caractérisé en ce que** le matériau de couche de protection présente une pression de vapeur qui est inférieure à la pression ambiante prévue lors du procédé de fabrication, et
lors du procédé d'impression, des zones des contacts et/ou des barres omnibus sont maintenues exemptes de matériau de couche de protection (5), et/ou la réticulation a lieu par réticulation par UV ou une autre source de rayonnement de manière sélective, de telle sorte que des zones de contact restent non réticulées et peuvent être facilement essuyées, rincées ou autrement débarrassées du matériau de couche protection liquide (5), tandis que les autres zones sont déjà réticulées et solidement reliées au support.

2. Procédé selon la revendication 1, dans lequel le matériau de couche de protection (5) présente une viscosité d'au maximum 10 000 mPa.s dans la phase de l'application.

3. Procédé selon la revendication 1 ou 2, dans lequel le matériau de couche de protection (5) présente une viscosité minimale d'environ 10 mPa.s, de préférence d'environ 10² mPa.s.

4. Procédé selon l'une quelconque des revendications précédentes, dans lequel la couche de protection d'enroulement fonctionnelle (4) est fabriquée avec une épaisseur d'au moins 50 nm et d'au plus 200 µm.

5. Procédé selon l'une quelconque des revendications précédentes, dans lequel la couche de protection d'enroulement fonctionnelle (4) est fabriquée avec une épaisseur d'au moins 5 µm et d'au plus 100 µm.

6. Procédé selon l'une quelconque des revendications précédentes, dans lequel la couche de protection d'enroulement (4) reçoit une structuration déterminée.

7. Procédé selon la revendication 1, dans lequel au moins l'un des groupes de matériaux parmi les thermoplastiques, les thermodurcissables ou les élastomères est prévu en tant que matériau de couche de protection (5).

8. Procédé selon la revendication 1, dans lequel au moins l'un des groupes de matériaux parmi les phénoplastes, les aminoplastes, les résines de polyesters insaturés, les résines d'esters de vinyle, les résines époxydes, les résines de silicone, le dicyclopentadiène ou les résines de phtalate de diallyle est prévu en tant que matériau de couche de protection (5).

9. Procédé selon la revendication 1, dans lequel des polyoléfines aromatiques, aliphatiques, sans halogène ou halogénées ; des polyesters aromatiques, aliphatiques, saturés ou insaturés ; des polyamides, des époxysiloxanes, des polyuréthanes, des résines de phénol-formaldéhyde ou des poly(organo)siloxanes sont prévus en tant que matériau de couche de protection (5) .

10. Procédé selon l'une quelconque des revendications 1, 7 à 9, dans lequel une combinaison de plusieurs matériaux des groupes de matériaux mentionnés dans l'une quelconque des revendications 7 à 9 est utilisée en tant que matériau de couche de protection (5).

11. Procédé selon l'une quelconque des revendications précédentes, **caractérisé en ce qu'**après l'application de la couche de protection d'enroulement fonctionnelle (4), une couche supplémentaire (Z2) est appliquée sur la couche de protection d'enroulement fonctionnelle (4), de telle sorte que la couche de protection d'enroulement fonctionnelle (4) ne se détache pas de l'empilement de couches (3) lors du traitement ultérieur du produit semi-fini.

12. Procédé selon la revendication 11, dans lequel le matériau de la couche supplémentaire (Z2) est choisi parmi les groupes de matériaux correspondant au matériau de couche de protection (5).

13. Procédé selon la revendication 11, dans lequel le matériau de la couche supplémentaire (Z2) est appliqué sous forme de matériau transparent ou semi-transparent.

14. Procédé selon la revendication 11, dans lequel la couche supplémentaire (Z2) est appliquée sous forme de film temporaire (401), et peut être enlevée sans laisser de résidu avant la transformation en un état ultérieur, l'empilement de couches (3) n'étant pas détérioré lors du déroulement.

15. Procédé selon l'une quelconque des revendications précédentes, dans lequel la couche de protection d'enroulement fonctionnelle (4) remplit au moins l'une des fonctions supplémentaires parmi l'égalisation de hauteur avec l'empilement de couches (3), le lissage de l'empilement de couches (3), l'adhérence améliorée d'une encapsulation et le maintien libre de points de contact (9) ou présente un matériau de getter mélangé ou appliqué au moins sur l'empilement de couches (3) dans une étape de procédé précédente.

16. Procédé selon l'une quelconque des revendications précédentes, dans lequel le produit semi-fini (1) est un composant optoélectronique organique.

17. Procédé selon la revendication 16, dans lequel le produit semi-fini (1) est un composant optoélectronique organique, de préférence un composant photoactif organique, comprenant un empilement de couches (3) constitué de plusieurs couches, au moins la couche photoactive ou les couches photoactives étant constituées en partie ou en totalité de petites molécules organiques, qui sont de préférence appliquées par évaporation.

18. Procédé selon la revendication 16, dans lequel la couche de protection d'enroulement fonctionnelle (4) comprend, en tant que fonctions supplémentaires, une préparation d'effets optiques actifs après l'encapsulation.
